# EUROPEAN PATENT APPLICATION

(11) **EP 4 835 915 A1**
(43) Date of publication of application: **04.11.2026**
(21) Application number: 24912084.1
(22) Date of filing: 15.11.2024
(51) Int. Cl.: H01B 1/22, C09D 5/24, C09D 7/61, C09D 7/63, C09D 163/00, H10F 10/00, H10K 30/50, H10K 30/81

(54) **CONDUCTIVE PASTE COMPOSITION AND SOLAR BATTERY CELL**

(30) Priority: 27.12.2023 JP 2023220802
(71) Applicant: Kyoto Elex Co., Ltd., Kyoto-shi, Kyoto 601-8391 (JP)
(72) Inventor: AKIOKA Nobuhiro, Kyoto-shi, Kyoto 601-8391 (JP); MATSUBARA Toyoharu, Kyoto-shi, Kyoto 601-8391 (JP); SAITO Yu, Kyoto-shi, Kyoto 601-8391 (JP); MOTOHISA Yuta, Kyoto-shi, Kyoto 601-8391 (JP); KITAZUMI Tatsuya, Kyoto-shi, Kyoto 601-8391 (JP)
(74) Representative: Hoffmann Eitle
(86) International application number: PCT/JP2024/040713
(87) International publication number: WO 2025/142191

(57) **Abstract**

Provided is a conductive paste composition that can be cured at a temperature lower than temperatures for conventional products, that can form a cured film having excellent conductivity, and that has excellent printability. A conductive paste composition according to the present invention contains a conductive material (A), an epoxy resin (B), a metal chelate (C), and a polyhydroxy fatty acid (D). The epoxy resin (B) has a weight average molecular weight of 2000-120000. The polyhydroxy fatty acid (D) is represented by general formula (1) (in formula (1), R¹ represents an alkylene group or an alkenylene group, R² and R³ are the same or different from each other and each represent a hydrogen atom, an alkyl group, or an alkenyl group, and n represents the number average degree of polymerization and is an integer of 2-20).

## Description

### TECHNICAL FIELD

The present invention relates to a conductive paste composition and a solar cell.

### BACKGROUND ART

In the related art, in a field of manufacturing electronic devices or electronic components, a technique using a conductive paste composition has been known as one of methods for forming an electrode, an electrical wiring, or the like on a base material, such as a film, a substrate, or an electronic component.

The conductive paste composition is a material containing a conductive material including conductive particles, such as silver particles, as a main component and capable of forming a cured film having conductivity by thermal curing. For example, the cured film can be formed by applying or pattern-printing the conductive paste composition on the base material and drying and curing the conductive paste composition by heating. Such a cured film has conductivity due to the conductive material and thus can function as a conductive layer, and has extremely high utility, for example, when used for an electrode for a solar cell as proposed in Patent Literature 1.

### CITATION LIST

### PATENT LITERATURE

Patent Literature 1: JP2020-205245A

### SUMMARY OF INVENTION

### TECHNICAL PROBLEM

Since the conductive paste composition is generally cured at a temperature of about 200°C to form the cured film on the base material, for example, it may be less likely to apply such a conductive paste composition to a base material that is easily damaged by heat. In this regard, it is also conceivable to cure the conductive paste composition at a temperature lower than 200°C, but in this case, the formation of the cured film may be insufficient, and a resistance value (particularly, a volume resistivity) of the cured film may be likely to increase. Due to such circumstances, it has been urgently required to develop a conductive paste composition capable of forming a cured film at a temperature lower than that in the related art. In particular, since a perovskite-type solar cell is easily damaged by heat at about 200°C, a conductive paste composition that can form a cured film excellent in conductivity at a low temperature has been strongly demanded.

The present invention has been made in view of the above, and an object thereof is to provide a conductive paste composition that can be cured at a temperature lower than that in the related art, can form a cured film having excellent conductivity, and has excellent printability, and a solar cell including a cured film of the paste composition.

### SOLUTION TO PROBLEM

As a result of intensive studies to achieve the above object, the present inventors have found that the above object can be achieved by using a specific component as an essential component, and have completed the present invention.

That is, the present invention includes, for example, subjects described in the following items.

### Item 1

A conductive paste composition including:
a conductive material (A);
an epoxy resin (B);
a metal chelate (C); and
a polyhydroxy fatty acid (D), in which
the epoxy resin (B) has a weight average molecular weight of 2000 or more and 120000 or less, and
the polyhydroxy fatty acid (D) is represented by the following general formula (1): 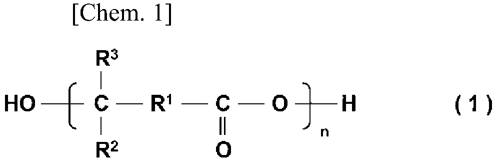
(in Formula (1), R¹ represents an alkylene group or an alkenylene group, R² and R³ are the same or different and represent a hydrogen atom, an alkyl group, or an alkenyl group, and n is a number average degree of polymerization and is an integer of 2 to 20).

### Item 2

The conductive paste composition according to Item 1, in which
the number average degree of polymerization is 2 or more and 8 or less.

### Item 3

The conductive paste composition according to Item 1 or 2, in which
the polyhydroxy fatty acid (D) has a constituent unit derived from a hydroxy fatty acid having 12 or more and 22 or less carbon atoms.

### Item 4

The conductive paste composition according to any one of Items 1 to 3, which is used for a solar cell.

### Item 5

A solar cell including:
a collecting electrode on which a cured film of the conductive paste composition according to Item 4 is formed.

### Item 6

A solar cell module including:
the solar cell according to Item 5.

### Item 7

A cured film including:
a cured product of the conductive paste composition according to any one of items 1 to 4.

### ADVANTAGEOUS EFFECTS OF INVENTION

The conductive paste composition according to the present invention can be cured at a temperature lower than that in the related art, can form a cured film having excellent conductivity, and has excellent printability.

### DESCRIPTION OF EMBODIMENTS

Hereinafter, an embodiment according to the present invention will be described in detail. In the present description, expressions "contain" and "include" include concepts of "contain", "include", "consist essentially of", and "consist of".

In numerical ranges described stepwise in the present description, an upper limit value or a lower limit value of the numerical range at a certain stage can be freely combined with an upper limit value or a lower limit value of the numerical range at another stage. In the numerical range described in the present description, the upper limit value or the lower limit value of the numerical range may be replaced with a value described in an example or a value unambiguously derived from the example. In the present description, numerical values connected by "to" mean a numerical range including numerical values before and after "to" as a lower limit value and an upper limit value.

A conductive paste composition according to the present invention includes a conductive material (A), an epoxy resin (B), a metal chelate (C), and a polyhydroxy fatty acid (D), and the epoxy resin (B) has a weight average molecular weight of 2000 or more and 120000 or less. The polyhydroxy fatty acid (D) is represented by the following general formula (1).

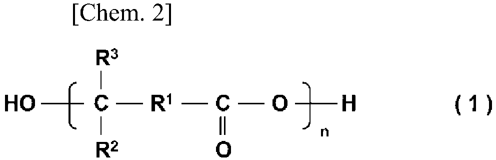

Here, in Formula (1), R¹ represents an alkylene group or an alkenylene group, R² and R³ are the same or different and represent a hydrogen atom, an alkyl group, or an alkenyl group, and n is a number average degree of polymerization and is an integer of 2 to 20.

Hereinafter, the conductive material (A), the epoxy resin (B), the metal chelate (C), and the polyhydroxy fatty acid (D) may be referred to as a conductive material, an epoxy resin, a metal chelate, and a polyhydroxy fatty acid, respectively, or may be referred to as a component (A), a component (B), a component (C), and a component (D), respectively.

According to such a conductive paste composition, by including the component (A), the component (B), the component (C), and the component (D) as essential components, it is possible to perform curing at a temperature lower than that in the related art, and it is possible to form a cured film having excellent conductivity. Specifically, even when the conductive paste composition according to the present invention is cured at 200°C or lower (for example, at about 100°C) to form the cured film, such a cured film has a low volume resistivity and excellent conductivity. Such a cured film also has a small resistance (hereinafter, referred to as a "contact resistance") when in contact with an ITO or an AZO (both are transparent conductive films).

Since the conductive paste composition according to the present invention includes the component (A), the component (B), the component (C), and the component (D) as the essential components, printability, particularly screen printability, is also excellent. Therefore, the conductive paste composition according to the present invention can be suitably used for forming various electronic devices, electrodes and wirings of electronic components, and the like. In particular, the conductive paste composition according to the present invention is particularly suitable for forming an electrode used in a perovskite-type solar cell.

### Conductive Material (A)

The conductive paste composition according to the present invention includes the conductive material as the component (A). The conductive material plays a role in imparting conductivity to the cured film formed of the conductive paste composition.

A type of the conductive material is not particularly limited, and for example, a conductive material contained in a known conductive paste composition used for producing an electrode for a solar cell can be widely used.

A specific shape of the conductive material is not particularly limited, and may be, for example, particulate, that is, the conductive material may be conductive particles. Alternatively, the conductive material may have a flake shape, such as a lamellar shape or a scale shape. The conductive particle has, for example, a spherical shape. Such a spherical shape includes a three-dimensional shape closer to a cube than a rectangular parallelepiped when viewed as a whole even when partial uneven or deformation is observed, and may be substantially a spherical shape or elliptical. The "flake shape" also includes powders having a shape close to a flat plate or a rectangular parallelepiped with a small thickness as a whole even when partial uneven or deformation is observed. The conductive material may be a mixture of the conductive particles and flakes.

Specific examples of the conductive material include conductive particles, such as silver powder, copper powder, gold powder, palladium powder, nickel powder, aluminum powder, lead powder, and carbon powder, and the conductive particles may be alloy powder. For example, the silver powder includes silver alloy powder, the copper powder includes copper alloy powder, and the gold powder includes gold alloy powder. The conductive material may have a flake shape, and examples thereof include silver flakes, copper flakes, and gold flakes.

Other examples of the conductive material include powder obtained by coating a core material with a metal and flakes obtained by coating a core material with a metal. Examples of the core material include metals such as silver, copper, gold, palladium, nickel powder, and aluminum, various resins such as a polyimide resin, and other ceramic materials. Examples of the powder obtained by coating the core material with a metal include copper powder coated with silver, copper alloy powder coated with silver, nickel powder coated with silver, and aluminum powder coated with silver.

The conductive material is preferably silver particles, silver flakes, or powder obtained by coating the core material with silver.

An average particle diameter D50 of the conductive material can be, for example, in a range of 0.1 µm to 10 µm when the conductive material is spherical particles. When the conductive material has a flake shape, the average particle diameter D50 can be, for example, in a range of 2 µm to 20 µm. The average particle diameter D50 of the conductive material can be measured by a laser diffraction method using a microtrack particle size distribution measurement device.

A production method of the conductive material is not particularly limited. For example, the conductive material can be obtained by a known production method, or can be obtained from a commercially available product or the like.

The conductive material (A) included in the conductive paste composition according to the present invention may be only one type or two or more types.

### Epoxy Resin (B)

The conductive paste composition according to the present invention includes an epoxy resin having a weight average molecular weight of 2000 or more and 120000 or less as the component (B). When the weight average molecular weight of the epoxy resin is less than 2000, the volume resistivity and the contact resistance of the cured film obtained when the conductive paste composition is cured at a low temperature may increase.

The weight average molecular weight of the epoxy resin is preferably 5000 or more, more preferably 10000 or more, and even more preferably 20000 or more, and is preferably 100000 or less, more preferably 90000 or less, and even more preferably 80000 or less.

The weight average molecular weight of the epoxy resin refers to polystyrene-equivalent weight average molecular weight measured by a gel permeation chromatography (GPC) method. A GPC device used in the GPC method is not particularly limited, and a commercially available GPC measurement device can be used. Specific measurement conditions are as follows.
Column: Shodex OHPak SB-806M HQ
Column temperature: 50°C
Detector: differential refractive index detector RID-20A (Shimadzu Corporation)
Flow rate: 0.5 ml/min

When a value guaranteed by a manufacturer or a measured value of the weight average molecular weight of the epoxy resin is known, the value can be used as the weight average molecular weight of the epoxy resin.

A type of the epoxy resin is not limited as long as the weight average molecular weight is 2000 or more and 120000 or less, and for example, epoxy resins included in known conductive paste compositions can be widely used.

Examples of the epoxy resin include a polyvalent epoxy resin having two or more epoxy rings or epoxy groups in one molecule, and the epoxy resin may have one or more hydroxyl groups.

Specific examples of the epoxy resin include glycidyl type epoxy resins, alicyclic epoxy resins such as dicyclopentadiene epoxide, and aliphatic epoxy resins such as butadiene dimer diepoxide. Examples of the glycidyl type epoxy resin include resins obtained by reacting epichlorohydrin or 2-methylepichlorohydrin with a compound having active hydrogen. Examples of the compound having active hydrogen include novolac compounds such as phenol novolac and cresol novolac, polyvalent phenol compounds and phenoxy resins such as bisphenol, bisphenol A, hydrogenated bisphenol A, bisphenol F, bisphenol S, bisphenol AD, and resorcin, polyvalent alcohol compounds such as ethylene glycol, neopentyl glycol, glycerin, trimethylolpropane, pentaerythritol, triethylene glycol, and polypropylene glycol, polyamino compounds such as ethylenediamine, triethylenetetramine, and aniline, and polyvalent carboxyl compounds such as adipic acid, phthalic acid, and isophthalic acid.

Among these, the epoxy resin is preferably a polyvalent phenol compound, and particularly preferably a phenoxy resin, which is a bisphenol type polymer epoxy resin.

The epoxy resin included in the conductive paste composition according to the present invention may be one type alone or two or more types.

The epoxy resin may include a blocked polyisocyanate compound. In this case, such a blocked polyisocyanate compound is also regarded as the component (B) for convenience. Examples of the blocked polyisocyanate compound include aromatic isocyanates such as tolylene diisocyanate, diphenylmethane diisocyanate, polymethylene polyphenyl polyisocyanate, tolidine diisocyanate, xylylene diisocyanate, and naphthalene diisocyanate, and aliphatic polyisocyanates such as hexamethylene diisocyanate, isophorone diisocyanate, hydrogenated xylylene diisocyanate, dicyclohexylmethane diisocyanate, octamethylene diisocyanate, and trimethylhexamethylene diisocyanate. These polyisocyanate compounds may be used alone, or may be appropriately combined with two or more types and used. These polyisocyanate compounds may be of an isocyanurate type, an adduct type, or a biuret type.

The polyisocyanate compound may be, for example, a terminal-isocyanate-group-containing compound synthesized by reacting a known polyisocyanate with a known polyol by a known method. Examples of the polyol include polyether polyols, polyester polyols, polycarbonate polyols, and polyalkylene polyols.

A production method of the epoxy resin is not particularly limited, and, for example, known production methods can be widely used. The epoxy resin can also be obtained from a commercially available product or the like.

The epoxy resin (B) included in the conductive paste composition according to the present invention may be only one type or two or more types.

### Metal Chelate (C)

The conductive paste composition according to the present invention includes a metal chelate as the component (C). When the conductive paste composition according to the present invention includes the metal chelate, the volume resistivity and the contact resistance of the cured film obtained even when the conductive paste composition is cured at a low temperature are small.

The metal chelate may be capable of so-called pseudo-crosslinking with the epoxy resin, which is the component (B), and accordingly, the volume resistivity and the contact resistance of the cured film obtained even when the conductive paste composition is cured at a low temperature are likely to be small. In particular, when the epoxy resin has a hydroxyl group, pseudo-crosslinking of the metal chelate with the epoxy resin is likely to occur.

Examples of the metal chelate include a chelate compound obtained by reacting a metal alkoxide with a chelating agent such as β-diketone or keto ester (such as ethyl acetoacetate). Specific examples of the metal chelate include an aluminum chelate, a zirconium chelate, and a titanium chelate, and the aluminum chelate is preferable.

As the aluminum chelate, for example, an acetylacetonate complex of aluminum is preferable. The acetylacetonate complex may have an acetylacetonate group of -O-C(CH₃)=CH-CO(CH₃), a methyl acetoacetate group of -O-C(CH₃)=CH-CO-O-CH₃, an ethyl acetoacetate group of -O-C(CH₃)=CH-CO-O-C₂H₅, or the like. As the aluminum chelate, the aluminum chelate preferably has one to three of these groups in one molecule, and more preferably has one to three of acetylacetonate groups or one to three of ethyl acetoacetate groups.

Further specific examples of the aluminum chelate include ethyl acetoacetate aluminum diisopropionate, aluminum tris (ethyl acetoacetate), alkyl acetoacetate aluminum diisopropylate, aluminum tris (acetyl acetate), aluminum monoacetyl acetate bis (ethyl acetoacetate), aluminum di-n-butoxide monomethyl acetoacetate, aluminum diisobutoxide monomethyl acetoacetate, and aluminum di-sec-butoxide monomethyl acetoacetate.

The metal chelate included in the conductive paste composition according to the present invention may be one type alone or two or more types.

A production method of the metal chelate is not particularly limited, and, for example, known production methods can be widely used. The metal chelate can also be obtained from a commercially available product or the like.

### Polyhydroxy Fatty Acid (D)

The conductive paste composition according to the present invention includes a polyhydroxy fatty acid as the component (D). By including the polyhydroxy fatty acid, the volume resistivity and the contact resistance of the cured film obtained even when the conductive paste composition is cured at a low temperature are small, the conductivity is excellent, and the screen printability is remarkably improved.

The polyhydroxy fatty acid is a compound having a constituent unit derived from a hydroxy fatty acid as a repeating unit. Specifically, the polyhydroxy fatty acid is a compound (oligomer or polymer) represented by Formula (1).

In Formula (1), R¹ represents an alkylene group or an alkenylene group. Therefore, it can be said that the polyhydroxy fatty acid is a compound having a constituent unit derived from a hydroxy saturated fatty acid as a repeating unit, or a compound having a constituent unit derived from a hydroxy unsaturated fatty acid as a repeating unit. The alkylene group is a divalent group obtained by removing two hydrogens from a linear alkane, and the alkenylene group is a divalent group obtained by removing two hydrogens from a linear alkene.

When R¹ represents an alkylene group, the number of carbon atoms in such an alkylene group is preferably 4 to 20 (that is, R¹ is preferably a group represented by -(CH₂)ₘ-(where m is 4 to 20)), more preferably 6 to 16, and even more preferably 8 to 12.

When R¹ represents an alkenylene group, the number of carbon atoms in such an alkenylene group is preferably 4 to 20, more preferably 6 to 16, even more preferably 8 to 12, and particularly preferably 9 to 11. In the alkenylene group, the number of double bonds is not particularly limited, and may be one, may be two or more, is preferably three or less, and more preferably two or less. In the alkenylene group, a position of the double bond is also not particularly limited.

Both the alkylene group and the alkenylene group are preferably linear. Both the alkylene group and the alkenylene group may have a substituent or may not have a substituent.

In Formula (1), R² and R³ are the same or different and represent a hydrogen atom, a alkyl group or an alkenyl group.

The number of carbon atoms in the alkyl group in R² and R³ is preferably 1 to 10, more preferably 2 to 8, even more preferably 3 to 7, and particularly preferably 3 to 6. The number of carbon atoms in the alkenyl group in R² and R³ is preferably 1 to 10, more preferably 2 to 8, even more preferably 3 to 7, and particularly preferably 3 to 6. In the alkenyl group, the number of double bonds is not particularly limited, may be one, may be two or more, is preferably three or less, and more preferably two or less. In the alkenylene group, a position of the double bond is also not particularly limited.

In R² and R³, both the alkyl group and the alkenyl group are preferably linear. Both the alkyl group and the alkenyl group may have a substituent or may not have a substituent.

In Formula (1), both R² and R³ may be hydrogen. Preferably, at least one of R² and R³ represents hydrogen, and the other is the alkyl group or the alkenyl group.

In Formula (1), n represents the number average degree of polymerization, that is, refers to the number of repeating units of the compound represented by Formula (1). n is an integer of 2 to 20, and is preferably 2 or more and 8 or less. That is, the number average degree of polymerization of the polyhydroxy fatty acid (D) is preferably 2 or more and 8 or less. In this case, the volume resistivity and the contact resistance of the cured film obtained even when the conductive paste composition is cured at a low temperature are small, and the screen printability is particularly remarkably improved. n is more preferably 3 or more, and is more preferably 6 or less.

The polyhydroxy fatty acid (D) preferably has a constituent unit derived from a hydroxy fatty acid having 12 or more and 22 or less carbon atoms. In other words, in Formula (1), a total number of carbons present in a structure of the repeating unit is preferably 12 or more and 22 or less. It is one aspect of the polyhydroxy fatty acid (D). Also in this case, the volume resistivity and the contact resistance of the cured film obtained even when the conductive paste composition is cured at a low temperature are small, and the screen printability is particularly remarkably improved. A preferred embodiment of the polyhydroxy fatty acid (D) has the constituent unit derived from the hydroxy fatty acid having 12 or more and 22 or less carbon atoms, and has a number average degree of polymerization of 2 or more and 8 or less.

Specific examples of the polyhydroxy fatty acid (D) include
polyhydroxy stearic acid (that is, in Formula (1), R¹ represents an alkylene group having 10 carbon atoms, R² represents an alkyl group having 6 carbon atoms, and R³ represents hydrogen), and polyricinoleic acid (that is, in Formula (1), R¹ represents an alkenylene group having 10 carbon atoms, R² represents an alkyl group having 6 carbon atoms, and R³ represents hydrogen).

The polyhydroxy fatty acid (D) included in the conductive paste composition according to the present invention may be one type alone or two or more types.

A production method of the polyhydroxy fatty acid (D) is not particularly limited, and, for example, known production methods can be widely used. The polyhydroxy fatty acid can also be obtained from a commercially available product or the like.

### Conductive Paste Composition

The conductive paste composition according to the present invention includes the component (A), the component (B), the component (C), and the component (D) as the essential components.

A content of the conductive material (A) is preferably 1000 parts by mass or more, more preferably 1250 parts by mass or more, even more preferably 1300 parts by mass or more, and particularly preferably 1500 parts by mass or more, and is preferably 5000 parts by mass or less, more preferably 4000 parts by mass or less, even more preferably 3500 parts by mass or less, and particularly preferably 3000 parts by mass or less, with respect to 100 parts by mass of the epoxy resin (B), from the viewpoint of easily imparting good conductivity to the cured film and easily improving the screen printability.

A content of the metal chelate (C) is preferably 1 part by mass or more, more preferably 5 parts by mass or more, even more preferably 10 parts by mass or more, and particularly preferably 15 parts by mass or more, and is preferably 50 parts by mass or less, more preferably 40 parts by mass or less, even more preferably 35 parts by mass or less, and particularly preferably 30 parts by mass or less, with respect to 100 parts by mass of the epoxy resin (B), from the viewpoint of easily reducing the volume resistivity of the cured film.

A content of the polyhydroxy fatty acid (D) is preferably 0.5 parts by mass or more, more preferably 1 part by mass or more, even more preferably 3 parts by mass or more, and particularly preferably 4 parts by mass or more, and is preferably 20 parts by mass or less, more preferably 15 parts by mass or less, even more preferably 12 parts by mass or less, and particularly preferably 10 parts by mass or less, with respect to 100 parts by mass of the epoxy resin (B), from the viewpoint of easily reducing the volume resistivity of the cured film and easily improving the screen printability.

In the conductive paste composition according to the present invention, components other than the component (A), the component (B), the component (C), and the component (D) can be included to an extent that the effects of the present invention are not impaired. Examples of other components include components included in the conductive paste composition in the related art, and in particular, components included in the conductive paste composition in the related art used for forming an electrode for a solar cell.

Other components include solvents, as well as, for example, leveling agents, antioxidants, UV absorbers, silane coupling agents, defoamers, and viscosity modifiers.

When the conductive paste composition includes a solvent, for example, physical properties such as viscosity or fluidity of the conductive paste composition are easily adjusted to a desired range. The viscosity of the conductive paste composition is not particularly limited, but for convenience when forming patterns of electrodes or wiring, and particularly for the efficiency of screen printing, it can be in a range of 75 Pa·s to 100 Pa·s. When the viscosity of the conductive paste composition is within this range, pattern formation by the screen printing can be performed satisfactorily.

A specific type of the solvent is not particularly limited, and examples thereof include saturated hydrocarbons such as n-hexane, aromatic hydrocarbons such as toluene, glycol ethers (cellosolves) such as ethyl cellosolve, butyl cellosolve, and butyl cellosolve acetate, glycol ethers such as diethylene glycol diethyl ether and butyl diglycol (butyl carbitol and diethylene glycol monobutyl ether), acetate esters of glycol ethers such as butyl diglycol acetate, butyl carbitol acetate, diethylene glycol monoethyl ether acetate, and diethylene glycol monobutyl ether acetate, alcohols such as diacetone alcohol, terpineol, and benzyl alcohol, ketones such as cyclohexanone and methyl ethyl ketone, and esters such as DBE, 2,2,4-trimethyl-1,3-pentanediol monoisobutyrate, and 2,2,4-trimethyl-1,3-pentanediol diisobutyrate. Only one type of these solvents may be used or combination of two or more types thereof may be used appropriately.

A content of the solvent in the conductive paste composition is not particularly limited, and, for example, the content of the solvent can be adjusted such that the viscosity of the conductive paste composition is adjusted to an appropriate range. For example, a content ratio of the solvent with respect to the entire conductive paste composition is preferably 1% by mass to 40% by mass from a viewpoint of easily improving the printability.

The content ratio of the component (A), the component (B), the component (C), the component (D), and the solvent with respect to a total amount of the conductive paste composition is preferably 80% by mass or more, more preferably 90% by mass or more, and even more preferably 95% by mass or more. Only the component (A), the component (B), the component (C), and the component (D) with respect to the total amount of the conductive paste composition may be included, or only the component (A), the component (B), the component (C), the component (D), and the solvent may be included.

A method of preparing the conductive paste composition according to the present invention is not particularly limited. For example, the conductive paste composition can be prepared by a method of mixing the component (A), the component (B), the component (C), the component (D), and other components such as a solvent added as necessary in predetermined blending amounts.

By using the conductive paste composition according to the present invention, an electrode or an electrical wiring can be formed on the base material. A formation method thereof is not particularly limited, and, for example, known methods can be widely used. Typically, examples include a method in which a pattern is formed by the screen printing, and then the conductive paste composition (formed pattern) is cured by a heating treatment. In addition to screen printing, other printing methods such as gravure printing, offset printing, inkjet printing, dispenser printing, and dip printing can also be applied.

Conditions for the heating treatment may be the same as conditions in the related art, but as described above, the conductive paste composition according to the present invention can be cured at a temperature lower than that in the related art. Therefore, a heating temperature is preferably 180°C or lower, more preferably 150°C or lower, even more preferably 130°C or lower, and particularly preferably 120°C or lower. The heating temperature may be 100°C. A lower limit of the heating temperature is not particularly limited as long as curing of the conductive paste composition proceeds, and is, for example, 60°C or higher, preferably 80°C or higher. A time of the heating treatment can be set to an appropriate range according to the heating temperature and a degree of progress of curing. A heating method in the heating treatment is also not particularly limited, and known heating methods can be widely used.

As described above, the conductive paste composition according to the present invention can be cured at a temperature lower than that in the related art, and can form a cured film having excellent conductivity. In particular, even when the conductive paste composition according to the present invention is cured at 200°C or lower (for example, about 100°C) to form the cured film, such a cured film has a low volume resistivity, excellent conductivity, and a low resistance when in contact with a transparent conductive film such as ITO or AZO.

Therefore, the conductive paste composition according to the present invention can be widely applied to applications requiring the formation of the cured film at a low temperature, and among these applications, is particularly suitable for use in forming a collecting electrode used in a heterojunction crystalline silicon solar cell or a perovskite-type solar cell requiring a treatment at a low temperature. That is, the conductive paste composition according to the present invention can be suitably used for solar cells.

Particularly, since a tandem solar cell including a perovskite solar cell and a crystalline silicon solar cell, which have attracted attention in recent years, is easily damaged by heat, the conductive paste composition according to the present invention capable of forming a collecting electrode at a low temperature can be suitably used.

The conductive paste composition according to the present invention can of course be used as a material for forming a collecting electrode of a solar cell other than the above, and can be suitably used for applications such as an external electrode of a chip-type electronic component, and an electrode or an electrical wiring of a component used for RFID, an electromagnetic wave shield, vibrator adhesion, a membrane switch, or electroluminescence. For example, since the solar cell includes a collecting electrode on which the cured film of the conductive paste composition according to the present invention is formed, it is easy to produce, and since the collecting electrode is particularly formed by a low-temperature treatment, it is less likely to be damaged in a production process and can have excellent performance.

In specifying the invention included in the present disclosure, the configurations (properties, structures, functions, and the like) described in the embodiment of the present disclosure may be combined in any manner. That is, the present disclosure encompasses all subject matters formed by any combination of the combinable configurations described in the present description.

### Examples

Hereinafter, the present invention will be more specifically described with reference to examples, but the present invention is not limited to aspects of these Examples.

### (Raw Materials)

In each of Examples and Comparative examples, the following was used as raw materials for preparing the conductive paste composition.

Component (A): conductive material
·Conductive material 1: AG-3-1F (silver, D50: 1.4 µm, spherical shape)
·Conductive material 2: AG-5-1F (silver, D50: 2.9 µm, spherical shape)
·Conductive material 3: AG-2-8F (silver, D50: 0.9 µm, spherical shape)
·Conductive material 4: mixture of FA-2-3 (silver, D50: 6.0 µm, flake) and AG-3-1F (silver, D50: 1.4 µm, spherical shape)
·Conductive material 5: TOYAL TecFiller TFM-C05P (silver-coated copper, D50: 6 µm, spherical shape, Toyo Aluminum K.K.)

Component (B): epoxy resin
·Epoxy resin 1: PKHB (weight average molecular weight: 32000, TOMOE Engineering Co., Ltd.)
·Epoxy resin 2: jER4007P (weight average molecular weight: 4000, Mitsubishi Chemical Corporation)
·Epoxy resin 3: PKFE (weight average molecular weight: 60000, TOMOE Engineering Co., Ltd.)
·Epoxy resin 4: YX7553BH30 (weight average molecular weight: 35000, Mitsubishi Chemical Corporation)

### Component (C): metal chelate

·Metal chelate 1: ORGATIX AL-3100 (Matsumoto Fine Chemical Co., Ltd.)
·Metal chelate 2: ORGATIX AL-3215 (Matsumoto Fine Chemical Co., Ltd.)
·Metal chelate 3: ORGATIX ZC-150 (Matsumoto Fine Chemical Co., Ltd.)

Component (D): polyhydroxy fatty acid
·Polyhydroxy fatty acid 1: polyhydroxy stearic acid having a number average degree of polymerization of 4 (manufactured by Kokura Gosei Kogyo. Ltd.)
·Polyhydroxy fatty acid 2: polyhydroxy stearic acid having a number average degree of polymerization of 2 (manufactured by Kokura Gosei Kogyo. Ltd.)
·Polyhydroxy fatty acid 3: polyhydroxy stearic acid having a number average degree of polymerization of 6 (manufactured by Kokura Gosei Kogyo. Ltd.)
·Polyhydroxy fatty acid 4: polyricinoleic acid having a number average degree of polymerization of 4 (manufactured by Kokura Gosei Kogyo. Ltd.)

### Component (D) for Comparison

·Stearic Acid

### Solvent

·Solvent 1: diethylene glycol monoethyl ether acetate
·Solvent 2: diethylene glycol monobutyl ether acetate

### (Example 1)

A conductive paste composition was prepared by selecting raw materials and blending amounts shown in Example 1 under blending conditions of Table 1. Specifically, the conductive paste composition was prepared by preparing and mixing 2500 parts by mass of the conductive material 1 as the component (A), 100 parts by mass of the epoxy resin 1 as the component (B), 20 parts by mass of the metal chelate 1 as the component (C), 6 parts by mass of the polyhydroxy fatty acid 1 as the component (D), and 60 parts by mass of the solvent 1 as the solvent.

### (Example 2 to Example 15 and Comparative Examples 1 to 3)

Conductive paste compositions were prepared in the same manner as in Example 1 except that raw materials and blending amounts were changed to those shown in the blending conditions of Table 1.

### (Formation of Cured Film)

Alumina was prepared as a substrate, and the conductive paste composition was screen-printed on a base material surface to form a conductor pattern. The substrate on which such a conductor pattern was formed was heated in a hot air dryer at 120°C for 15 minutes to cure the conductor pattern (conductive paste composition) and form the cured film. Accordingly, an evaluation sample 1 for the volume resistivity was prepared.

### (Evaluation Method)

### <Measurement of Volume Resistivity>

The volume resistivity was measured using the evaluation sample 1. First, regarding the conductor pattern (cured film) of evaluation sample 1, a thickness thereof was measured using a surface roughness meter (manufactured by Tokyo Seimitsu Co., Ltd., product name Surfcom 480A), and an electric resistance thereof was measured using a digital multimeter (manufactured by Advantest Corporation, product name R6551). The volume resistivity (µΩ · cm) was calculated based on the measured film thickness and electric resistance.

### <Measurement of Contact Resistance with ITO>

For measurement of the contact resistance with ITO, a glass substrate coated with ITO on a surface was used. An electrode was formed on the ITO glass substrate using a conductive paste of each of Examples and Comparative Examples, and then the contact resistance (ITO) was measured by a traansfer length method (TLM).

### <Measurement of Contact Resistance with AZO>

For measurement of the contact resistance with AZO, a glass substrate coated with AZO on a surface was used. An electrode was formed on the ITO glass substrate using a conductive paste of each of Examples and Comparative Examples, and then the contact resistance (AZO) was measured by the traansfer length method (TLM).

### <Screen Printability>

The conductor pattern after the screen printing performed in the above-described "formation of cured film" was visually observed, and the screen printability was evaluated based on the following criteria.

### ≪Determination Criteria≫

A: No blur was observed, and printability was good.
B: Blur was observed, and printability was poor.

Table 1 shows the blending conditions of the conductive paste compositions prepared in Examples and Comparative Examples, the volume resistivity, measurement results of the contact resistance with ITO and the contact resistance with AZO, and evaluation result of the screen printability of each of the obtained cured films. Blanks in the blending conditions in Table 1 mean that the raw materials were not used.

It can be seen from Table 1 that the cured films formed from the conductive paste compositions obtained in Examples have low volume resistivity, low contact resistance with ITO, low contact resistance with AZO, and excellent screen printability. That is, although the conductive paste compositions obtained in Examples were cured at a temperature lower than that in the related art to form the cured films, it was demonstrated that such a cured film had a low volume resistivity and a small contact resistance with ITO or AZO, and was also excellent in screen printability.

**[Table 1]**

| | | | Examples | | | | | | | | | | |
|---|---|---|---|---|---|---|---|---|---|---|---|---|---|
| | | | 1 | 2 | 3 | 4 | 5 | 6 | 7 | 8 | 9 | 10 | 11 |
| | A | Conductive material 1 | 2500 | | | | | 2500 | 2500 | 2500 | 2500 | 2500 | 2500 |
| | | Conductive material 2 | | 2500 | | | | | | | | | |
| | | Conductive material 3 | | | 2500 | | | | | | | | |
| | | Conductive material 4 | | | | 2500 | | | | | | | |
| | | Conductive material 5 | | | | | 2500 | | | | | | |
| | B | Epoxy resin 1 | 100 | 100 | 100 | 100 | 100 | | | | 100 | 100 | 100 |
| | | Epoxy resin 2 | | | | | | 100 | | | | | |
| | | Epoxy resin 3 | | | | | | | 100 | | | | |
| Blending conditions (parts by mass) | | Epoxy resin 4 | | | | | | | | 100 | | | |
| | C | Metal chelate 1 | 20 | 20 | 20 | 20 | 20 | 20 | 20 | 20 | | | 20 |
| | | Metal chelate 2 | | | | | | | | | 20 | | |
| | | Metal chelate 3 | | | | | | | | | | 20 | |
| | D | Polyhydroxy fatty acid 1 | 6 | 6 | 6 | 6 | 6 | 6 | 6 | 6 | 6 | 6 | |
| | | Polyhydroxy fatty acid 2 | | | | | | | | | | | 6 |
| | | Polyhydroxy fatty acid 3 | | | | | | | | | | | |
| | | Polyhydroxy fatty acid 4 | | | | | | | | | | | |
| | | Stearic acid (for comparison) | | | | | | | | | | | |
| | E | Solvent 1 | 60 | 60 | 60 | 60 | 60 | 60 | 60 | 60 | 60 | 60 | 60 |
| | | Solvent 2 | | | | | | | | | | | |
| Evaluations | | Volume resistivity | 1.0 | 1.1 | 1.0 | 0.9 | 1.5 | 0.9 | 1.1 | 1.0 | 1.0 | 1.0 | 1.0 |
| | | Contact resistance (ITO) | 1.0 | 1.1 | 1.0 | 1.0 | 1.0 | 1.0 | 1.0 | 1.0 | 1.0 | 1.2 | 1.0 |
| | | Contact resistance (AZO) | 1.0 | 1.2 | 1.0 | 1.0 | 1.0 | 1.0 | 1.0 | 1.0 | 1.0 | 1.3 | 1.0 |
| | | Screen printability | A | A | A | A | A | A | A | A | A | A | A |

**[Table 1] (continued)**

| | | | Examples | | | | | | | | Comparative Examples | | |
|---|---|---|---|---|---|---|---|---|---|---|---|---|---|
| | | | 12 | 13 | 14 | 15 | 16 | 17 | 18 | 19 | 1 | 2 | 3 |
| | A | Conductive material 1 | 2500 | 2500 | 2500 | 1250 | 2500 | 2500 | 2500 | 2500 | 2500 | 2500 | 2500 |
| | | Conductive material 2 | | | | | | | | | | | |
| | | Conductive material 3 | | | | | | | | | | | |
| | | Conductive material 4 | | | | | | | | | | | |
| | | Conductive material 5 | | | | | | | | | | | |
| | B | Epoxy resin 1 | 100 | 100 | 100 | 100 | 100 | 100 | 100 | 100 | 100 | 100 | 100 |
| | | Epoxy resin 2 | | | | | | | | | | | |
| | | Epoxy resin 3 | | | | | | | | | | | |
| Blending conditions (parts by mass) | | Epoxy resin 4 | | | | | | | | | | | |
| | C | Metal chelate 1 | 20 | 20 | 20 | 20 | 20 | 20 | 40 | 10 | | 20 | 20 |
| | | Metal chelate 2 | | | | | | | | | | | |
| | | Metal chelate 3 | | | | | | | | | | | |
| | D | Polyhydroxy fatty acid 1 | | | 6 | 6 | 12 | 3 | 6 | 6 | 6 | | |
| | | Polyhydroxy fatty acid 2 | | | | | | | | | | | |
| | | Polyhydroxy fatty acid 3 | 6 | | | | | | | | | | |
| | | Polyhydroxy fatty acid 4 | | 6 | | | | | | | | | |
| | | Stearic acid (for comparison) | | | | | | | | | | | 6 |
| | E | Solvent 1 | 60 | 60 | | 60 | 60 | 60 | 60 | 60 | 60 | 60 | 60 |
| | | Solvent 2 | | | 60 | | | | | | | | |
| Evaluations | | Volume resistivity | 1.0 | 1.0 | 1.0 | 1.3 | 1.0 | 1.0 | 1.0 | 1.1 | 5.0 | 2.0 | 2.0 |
| | | Contact resistance (ITO) | 1.0 | 1.0 | 1.0 | 1.0 | 1.0 | 1.1 | 1.0 | 1.2 | 10.0 | 3.0 | 2.5 |
| | | Contact resistance (AZO) | 1.0 | 1.0 | 1.0 | 1.0 | 1.0 | 1.2 | 1.0 | 1.3 | 15.0 | 5.0 | 4.0 |
| | | Screen printability | A | A | A | A | A | A | A | A | A | B | B |

## Claims

1. A conductive paste composition comprising:
a conductive material (A);
an epoxy resin (B);
a metal chelate (C); and
a polyhydroxy fatty acid (D), wherein
the epoxy resin (B) has a weight average molecular weight of 2000 or more and 120000 or less, and
the polyhydroxy fatty acid (D) is represented by the following general formula (1): 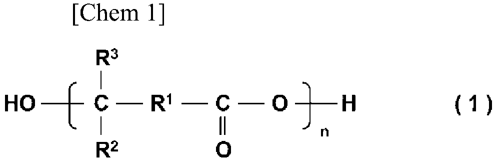
(in Formula (1), R¹ represents an alkylene group or an alkenylene group, R² and R³ are the same or different and represent a hydrogen atom, an alkyl group, or an alkenyl group, and n is a number average degree of polymerization and is an integer of 2 to 20).

2. The conductive paste composition according to claim 1, wherein
the number average degree of polymerization is 2 or more and 8 or less.

3. The conductive paste composition according to claim 1, wherein
the polyhydroxy fatty acid (D) has a constituent unit derived from a hydroxy fatty acid having 12 or more and 22 or less carbon atoms.

4. The conductive paste composition according to any one of claims 1 to 3, which is used for a solar cell.

5. A solar cell comprising:
a collecting electrode on which a cured film of the conductive paste composition according to claim 4 is formed.

6. A solar cell module comprising:
the solar cell according to claim 5.
